# EUROPÄISCHE PATENTSCHRIFT

(11) **EP 2 449 581 B1**
(45) Veröffentlichungstag und Bekanntmachung des Hinweises auf die Patenterteilung: **23.11.2016**
(21) Anmeldenummer: 10717637.2
(22) Anmeldetag: 30.04.2010
(51) Int. Cl.: H01L 21/56, H01L 23/31, G01D 11/24

(54) **VERFAHREN ZUR HERSTELLUNG EINES ELEKTRONISCHEN BAUTEILS**
METHOD FOR PRODUCING AN ELECTRONIC COMPONENT
PROCÉDÉ DE FABRICATION D'UN COMPOSANT ÉLECTRONIQUE

(30) Priorität: 30.06.2009 DE 102009027343
(43) Veröffentlichungstag der Anmeldung: 09.05.2012
(73) Patentinhaber: Robert Bosch GmbH, 70442 Stuttgart (DE)
(72) Erfinder: LUDWIG, Ronny, 72411 Bodelshausen (DE)
(86) Internationale Anmeldenummer: PCT/EP2010/055882
(87) Internationale Veröffentlichungsnummer: WO 2011/000597

(56) Entgegenhaltungen:
- WO-A2-99/16132
- DE-A1- 19 736 090
- DE-A1- 19 948 613
- GB-A- 1 329 810
- JP-A- 61 189 656
- US-A- 6 091 157

## Beschreibung

### Stand der Technik

Die vorliegende Erfindung betrifft ein Verfahren zur Herstellung eines elektronischen Bauteils, insbesondere eines Sensors zur Anwendung in einem Kraftfahrzeug. Desweiteren umfasst die Erfindung ein Spritzgießwerkzeug, wie es zur Durchführung des Verfahrens zur Anwendung kommt, sowie ein Trägerelement, ausgebildet zur Herstellung des elektronischen Bauteils.

DE 197 36 090 A1 zeigt ein Bauelement mit Schutzschicht und ein Verfahren zur Herstellung des Bauelements. Dabei erfolgt ein Beschichten von Oberflächen mit einer Schutzschicht, insbesondere für elektronische Bauelemente. Die Schutzschicht ändert ihre Eigenschaften über ihre Dicke. Weiterer relevanter Stand der Technik ist in den Druckschriften US 6 091 157 A, WO 99/16132 A2, GB 1 329 810 A, JP 61 189656 A und DE 199 48 613 A1 gezeigt.

Bekannte Konzepte in der Aufbau- und Verbindungstechnik von Sensoren verwenden immer kleiner werdende und vollintegrierte Lösungen zur Darstellung der Funktion. Gehäusekonzepte zur "Verpackung" von Sensorchips, z. B. "Land-Grid-Arrays", integrieren sämtliche Bauelemente einer Schaltung in eine winzige Umhüllung (Mold Compound), welche nur wenige Kubikmillimeter umfasst. Derartige miniaturisierte Schaltungen stellen eine enorme Herausforderung für das "Second-Level-Packaging", also die Weiterverarbeitung zu einem Sensor mit Befestigungsmöglichkeiten und Stecker, dar.

Da derartige miniaturisierte Schaltungen wie z. B. LGAs keine Leiterplatte oder anderweitige Schaltungsträger mehr benötigen, werden diese typischerweise direkt in umgebende Sensorgehäuse montiert. Als Ansatz dient hier das 2-Komponenten-Spritzgiessverfahren, bei dem das mit einem metallischen Trägerstreifen verbundene LGA-Gehäuse zuerst mit einem relativ weichen Material, z. B. Silikon, in einem ersten Schritt umspritzt wird und dieses Konstrukt in einem weiteren Schritt wiederum mittels Spritzgiessverfahren mit einem Gehäusekunststoff umspritzt wird. Diese Reihenfolge ist notwendig, da die beim Kunststoff-Spritzguss notwendigen Drücke von mehreren 100bar das LGA-Gehäuse derart schädigen würden, das zumindest die dauerhafte Funktion der

Schaltung nicht gewährleistet ist. Aber auch das vorherige Umspritzen mit einem dämpfenden Material, wie z. B. Silikon, stellt einige Gefahren dar: so z. B. eine Verschiebung des Silikon-Materials bei einseitig auftreffender Kunststoffmasse oder z. B. das Eindringen des Silikons durch den hohen anliegenden Druck beim Kunststoffspritzen in die elektrische Kontaktstelle zwischen LGA-Gehäuse und metallischen Trägerelement. Somit ist die Verwendung einer rein mechanischen Klemmverbindung für den elektronischen Kontakt fraglich und man muss auf materialschlüssige Verbindungen, z. B. Lötverbindungen, ausweichen. Diese dürfen durch die aktuellen RoHS Richtlinien (EG-Richtlinie 2002/95/EG zur Beschränkung der Verwendung bestimmter gefährlicher Stoffe in Elektro- und Elektronikgeräten) kein Blei enthalten und stellen durch den Inhalt von notwendigen Flussmitteln im Lot ein nicht unerhebliches Risiko für die Kontamination bzw. Verschleppung von Flussmittel in die Silikonmasse beim ersten Spritzgussvorgang dar. Bei Lötstellen ohne Blei entsteht zudem das Problem der Whiskerbildung.

### Offenbarung der Erfindung

Das erfindungsgemäße Verfahren zur Herstellung eines elektronischen Bauteils mit den Merkmalen des Anspruchs 1 ermöglicht diverse Kosteneinsparungsmöglichkeiten sowohl bei der Material- und Rohstoffauswahl als auch bei Herstellung und Montage. Dies wird u.a. dadurch erreicht, dass ein Mikrobauteil ohne Leiterplatte, ein sog. LGA, verwendet werden kann. Desweiteren kann, aufgrund der erfindungsgemäßen Reihenfolge der Verfahrensschritte, das Gehäuse unter üblichen Bedingungen, wie hohen Temperaturen und hohem Druck, gespritzt werden. Es muss dabei keine Rücksicht auf das Mikrobauteil genommen werden, da dieses zum Zeitpunkt des Gehäusespritzvorgangs noch nicht montiert ist. Ferner ist das Mikrobauteil nicht mehr über eine materialschlüssige Verbindung, wie beispielsweise Löten, anzubinden. Dadurch wurde die Aufgabe einer lötfreien und insbesondere bleifreien Verbindung auf einfache und kostengünstige Weise gelöst. Gleichzeitig wird eine Kontamination des Füllstoffes, z. B. Silikon, durch Flussmittel des Lotes vermieden. Das Einbringen des Füllmaterials ist mit sehr geringem Druck möglich, wodurch eine Stressbelastung des Mikrobauteils weitgehend vermieden wird. Ferner ermöglicht das erfindungsgemäße Verfahren eine äußerst variable Herstellung der elektronischen Bauteile. Es können durch die erfindungsgemäße Montagereihenfolge verschiedenste Mikrobauteile mit verschiedenen Baugrößen und/oder verschiedenen Anwendungsbereichen in dem gleichen Gehäuse montiert werden. All diese Vorteile werden ermöglicht durch ein erfindungsgemäßes Verfahren zur Herstellung eines elektronischen Bauteils, umfassend die in folgender Reihenfolge durchgeführten Schritte:
Bereitstellen zumindest eines Trägerelementes umfassend eine zur Kontaktierung zumindest eines Mikrobauteils ausgebildete Mikrobauteilaufnahme,
Umspritzen des Trägerelementes mit einem Gehäuse, wobei die Mikrobauteilaufnahme in einem zumindest einseitig offenen Hohlraum des Gehäuses angeordnet ist,
Einführen des zumindest einen Mikrobauteils in die Mikrobauteilaufnahme im Hohlraum, um das zumindest eine Mikrobauteil mit dem Trägerelement zu kontaktieren, und
Ausspritzen des Hohlraums mit einem Füllmaterial, um das kontaktierte, zumindest eine Mikrobauteil im Gehäuse und in der Mikrobauteilaufnahme zu fixieren.

Das Trägerelement ist vorteilhafterweise aus einem metallischen Werkstoff. Als Füllmaterial kommt vorteilhafterweise Silikon oder Schmelzklebstoff zum Einsatz. Das Füllmaterial übernimmt vorteilhafterweise mehrere Funktionen, wie beispielsweise den Schutz des Mikrobauteils vor Umwelteinflüssen, eine mechanische Fixierung und Festsetzung des Mikrobauteils im Gehäuse sowie eine Dämpfung des Mikrobauteils. Das Gehäuse besteht vorteilhafterweise aus einem Thermoplasten. Erfindungsgemäß wird also bei der Herstellung des elektronischen Bauteils zuerst das äußere Gehäuse mit dem Trägerelement als Einlegeteil gefertigt. Daraufhin wird das Mikrobauteil eingeschoben und mit dem Trägerelement kontaktiert. Um dieses Mikrobauteil in dem Gehäuse nun zu fixieren, wird der verbleibende Hohlraum mit Füllmaterial ausgespritzt. Die hohen Drücke und Temperaturen, welche zur Fertigung des Gehäuses nötig sind, belasten somit weder das Mikrobauteil, die Kontaktstellen zwischen Mikrobauteil und Trägerelement, noch das relativ weiche Füllmaterial. Bevorzugt ist das Einsetzen sowohl eines einzelnen Mikrobauteils als auch mehrerer Mikrobauteile in die Mikrobauteilaufnahme. Zur vereinfachten Darstellung wird im Folgenden die Variante mit einem Mikrobauteil dargestellt.

Die Unteransprüche zeigen bevorzugte Weiterbildungen der Erfindung.

In vorteilhafter Ausgestaltung umfasst das elektronische Bauteil zwei Trägerelemente und das Mikrobauteil umfasst zwei Kontaktpads. Die beiden Kontaktpads sind jeweils mit einer Mikrobauteilaufnahme eines Trägerelements kontaktiert, wobei die beiden Mikrobauteilaufnahmen der beiden Trägerelemente gemeinsam in dem Hohlraum angeordnet sind. Das Mikrobauteil kann somit über zwei voneinander isolierte metallische Trägerelemente kontaktiert werden.

In bevorzugter Ausführung ist der Hohlraum größer als das Mikrobauteil. Dadurch kann das Mikrobauteil, mit Ausnahme von Berührungsstellen von dem Mikrobauteil mit dem Trägerelement und/oder dem Gehäuse, vom Füllmaterial vollständig umhüllt werden. Solche Berührungsstellen sind in erster Linie die Kontakte zwischen Kontaktpad und Mikrobauteilaufnahme des Trägerelementes. Wie sich weiter zeigen wird, sind jedoch noch weitere Berührungsstellen möglich, wie beispielsweise die Berührung zwischen einem Anschlag ausgebildet am Trägerelement und dem Mikrobauteil. Ferner ist es möglich, dass das Mikrobauteil seitlich am Gehäuse, also der Innenwandung des Hohlraums, anliegt und dadurch geführt und/oder geklemmt wird.

Vorteilhafterweise ist vorgesehen, dass beim Einführen des Mikrobauteils in die Mikrobauteilaufnahme das Mikrobauteil in der Mikrobauteilaufnahme geklemmt wird. Wie oben bereits erwähnt, kann diese Klemmung dadurch erfolgen, dass das Mikrobauteil beispielsweise seitlich an der Innenwandung des Hohlraums anliegt und somit über die Innenwandung des Hohlraums sowohl geführt als auch geklemmt wird. Durch diese seitliche Führung des Mikrobauteils sind sehr enge Toleranzen bezüglich einer möglichen Verdrehung des Mikrobauteils einhaltbar. Alternativ oder zusätzlich zu dieser seitlichen Führung und/oder Klemmung des Mikrobauteils zwischen den Innenwänden des Hohlraums ist vor allem eine Klemmung des Mikrobauteils mittels eines Federelementes von Vorteil. Ein solches Federelement, insbesondere ausgebildet in der Mikrobauteilaufnahme am Trägerelement, dient sowohl zur Kontaktierung des Mikrobauteils als auch zur Klemmung des Mikrobauteils. Solch ein Federelement bleibt selbstverständlich bei dem Umspritzen des Trägerelements mit dem Gehäuse frei und wirkt vorteilhafterweise auf die Kontaktpads des Mikrobauteils. Die Lagetoleranz des Mikrobauteils innerhalb des Hohlraums ist durch diese Klemmung sehr eng einstellbar, d. h. das Mikrobauteil wird durch die Federelemente und/oder durch die seitliche Führung an den Innenwänden des Hohlraums sehr exakt geführt. Dadurch sind sehr geringe Soll- bzw. Querempfindlichkeitsfehler bei Verwendung eines Sensors im Mikrobauteil möglich. Zur endgültigen Fixierung des Mikrobauteils im Gehäuse wird natürlich zusätzlich zu der Klemmung der Hohlraum mit dem Füllmaterial ausgespritzt.

In bevorzugter Ausführung des erfindungsgemäßen Verfahrens ist die Verwendung eines mehrteiligen, insbesondere Zweikomponenten-Spritzgießwerkzeugs, vorgesehen. Dieses Spritzgießwerkzeug umfasst ein erstes Werkzeugteil mit einer ersten Spritzgießkavität, ein zweites Werkzeugteil mit einer zweiten Spritzgießkavität und einen Hohlraumschieber. Dabei bestimmen die erste Spritzgießkavität und die zweite Spritzgießkavität zusammen eine äußere Form des Gehäuses. Desweiteren erstreckt sich während des Umspritzens des Trägerelementes mit dem Gehäuse der Hohlraumschieber in die erste Spritzgießkavität und/oder die zweite Spritzgießkavität, um den Hohlraum zu bestimmen. Der Aufbau dieses Spritzgießwerkzeugs ermöglicht eine effiziente und kostengünstige Durchführung des Verfahrens. Die Verwendung des Hohlraumschiebers ermöglicht es, den Hohlraum exakt zu definieren, wobei insbesondere die Mikrobauteilaufnahme des Trägerelements bzw. der Trägerelemente frei von dem Material des Gehäuses bleibt.

Vorteilhafterweise verbleibt zum Einführen des Mikrobauteils in die Mikrobauteilaufnahme das Gehäuse im ersten Werkzeugteil. Der zweite Werkzeugteil und der Hohlraumschieber werden zum Einführen des Mikrobauteils vom Gehäuse beabstandet. Hierzu ist vorteilhafterweise der Hohlraumschieber im zweiten Werkzeugteil integriert. Der erste Werkzeugteil dient somit gleichzeitig als Halterung des Gehäuses bei der Montage des Mikrobauteils und ein zeitaufwändiges Umsetzen des Gehäuses wird vermieden.

Ferner bevorzugt ist es, dass zum Ausspritzen des Hohlraums mit dem Füllmaterial das Gehäuse im ersten Werkzeugteil verbleibt und über einen Einspritzschieber das Füllmaterial in den Hohlraum gespritzt wird. Somit verbleibt das Gehäuse auch bei diesem Verfahrensschritt, dem Einspritzen des Füllmaterials, im ersten Werkzeugteil. Dieses erste Werkzeugteil dient somit vorteilhafterweise als Befestigung und/oder Halterung des elektronischen Bauteils bis zu seiner Fertigstellung. Besonders bevorzugt wird zur Durchführung des erfindungsgemäßen Verfahrens ein Drehtisch mit zumindest vier Positionen verwendet. Auf diesem Drehtisch sitzt das erste Werkzeugteil, welches zu Beginn der Herstellung einen Teil der Kavität für das Gehäuse darstellt und im weiteren Verlauf der Herstellung eine Halterung des Gehäuses darstellt. Die vier Positionen bei der Herstellung sind vorteilhafterweise wie folgt:
An erster Position erfolgt das Spritzgießen des Gehäuses. An zweiter Position wird das Mikrobauteil in die Mikrobauteilaufnahme montiert bzw. eingeschoben. An der dritten Position erfolgt das Ausspritzen des Hohlraums mit dem Füllmaterial. An vierter Position erfolgen die Entnahme des fertigen elektronischen Bauteils sowie die Bestückung des Spritzgießwerkzeugs mit Trägerelementen und einer etwaigen Buchse für das darauffolgend herzustellende elektronische Bauteil.

In weiterer vorteilhafter Ausgestaltung ist vorgesehen, dass die erste Spritzgießkavität ein Befestigungsformelement des Gehäuses bestimmt. Über ein solches Befestigungsformelement kann das erfindungsgemäße elektronische Bauteil beispielsweise an seinem Bestimmungsort, insbesondere in einem Fahrzeug, angeschraubt werden. Durch Ausgestaltung des Befestigungsformelements in der ersten Spritzkavität und somit im ersten Werkzeugteil ist ein Formschluss zwischen Gehäuse und erstem Werkzeugteil während des Herstellungsprozesses gewährleistet, wodurch das erste Werkzeugteil besonders gut als Befestigung bzw. Halterung des Gehäuses über die gesamte Herstellung hinweg verwendet werden kann. Eine weitere bevorzugte Ausgestaltung sieht vor, dass der zweite Werkzeugteil einen Steckerhohlraumschieber umfasst, wobei während des Umspritzens des Trägerelements mit dem Gehäuse der Steckerhohlraumschieber einen Steckerhohlraum um einen Anschlusspin des Trägerelements herum bestimmt. Durch die individuelle Ausgestaltung des Befestigungsformelements und/oder des Steckerhohlraums können unabhängig vom Trägerelement und Mikrobauteil verschiedenste kundenindividuelle Stecksysteme, insbesondere für die Kraftfahrzeugtechnik, realisiert werden. Insbesondere sind dadurch auch VDA-Schnittstellen kostengünstig und effizient herstellbar.

Die Erfindung umfasst des weiteren ein Spritzgießwerkzeug, ausgebildet zur Durchführung des soeben beschriebenen Verfahrens. Die bereits diskutierten vorteilhaften Ausführungen des erfindungsgemäßen Verfahrens zur Herstellung des elektronischen Bauteils kommen selbstverständlich in entsprechender Weise auch bei dem erfindungsgemäßen Spritzgießwerkzeug vorteilhaft zur Anwendung.

Ferner umfasst die Erfindung ein Trägerelement, ausgebildet zur Herstellung des elektronischen Bauteils gemäß dem bereits beschriebenen Verfahren, umfassend die Mikrobauteilaufnahme mit einem zur Kontaktierung des Mikrobauteils ausgebildeten Federelement, einen zum direkten Umspritzen mit dem Gehäuse ausgebildeten Umspritzanteil, um das Trägerelement in dem Gehäuse zu fixieren, und einen Anschlusspin, welcher dazu ausgebildet ist, um vom Gehäuse und Füllmaterial frei zubleiben. Der Umspritzanteil steht dabei im fertigen elektronischen Bauteil in direktem Kontakt zum Material des Gehäuses und stellt somit die Verbindung zwischen Gehäuse und Trägerelement dar. Der Anschlusspin, bzw. die beiden Anschlusspins bei Verwendung von zwei Trägerelementen, müssen selbstverständlich von Gehäuse und Füllmaterial frei bleiben, da nur so ein elektrischer Kontakt zu einem Kabel oder Stecker gewährleistet werden kann. Eine Auslegung des Federelementes, also die Charakteristik seiner Federkennlinie, kann über die geometrische Auslegung sowie über die Dicke des Trägerelementes definiert werden. Die Mikrobauteilaufnahme des Trägerelements sowie der Hohlraum des elektronischen Bauteils sind dabei derart dimensioniert, dass die Federelemente nicht mit dem Material des Gehäuses in Berührung kommen, so dass die erforderliche Federwirkung zur Kontaktierung und/oder Klemmung des Mikrobauteils nicht beeinflusst wird.

In vorteilhafter Ausgestaltung des Trägerelementes ist vorgesehen, dass das Trägerelement aus einem Blech gestanzt ist und das Federelement derart ausgebildet ist, dass es das Mikrobauteil in einer Richtung parallel zur Ebene des Bleches beaufschlagt. Vorteilhafterweise entsteht also das Federelement nicht erst durch Herausbiegen eines Anteils des Trägerelements aus der Ebene des Bleches. Vielmehr wird das Federelement durch die Geometrie des Trägerelements bestimmt. Das fertige Trägerelement erstreckt sich somit in einer Richtung senkrecht zum Blech genauso weit wie das Blech dick ist. In weiterer vorteilhafter Ausgestaltung werden die Trägerelemente derart aus dem Blech gestanzt, dass sich ein Blechstanzband mit einer Vielzahl zusammenhängender Trägerelemente ergibt. Dadurch sind vorteilhafte Bandgalvanik-Prozesse möglich. Eine Vereinzelung der Trägerelemente erfolgt vorteilhafterweise durch einen Stanzprozess in der Endmontage.

In bevorzugter Ausführung umfasst die Mikrobauteilaufnahme einen Anschlag, um das Mikrobauteil exakt zu positionieren. Dadurch ist die Position des Mikrobauteils relativ zum Gehäuse bzw. relativ zum Trägerelement in einer Einschiebrichtung definiert.

Desweiteren umfasst die Erfindung einen Sensor, insbesondere Beschleunigungssensor, zur Anwendung in einem Kraftfahrzeug, umfassend ein elektronisches Bauteil, hergestellt nach dem bereits beschriebenen erfindungsgemäßen Verfahren, insbesondere mit dem erfindungsgemäßen Spritzgießwerkzeug und insbesondere mit dem erfindungsgemäßen Trägerelement, wobei das Mikrobauteil einen mikroelektromechanischen Sensor umfasst. Die beschriebenen Vorteile, beispielsweise die kostengünstige und prozesssichere Herstellung auch größerer Stückzahlen des elektronischen Bauteils, treten insbesondere bei Verwendung des elektronischen Bauteils als Sensor in der Kraftfahrzeugtechnik hervor. Weiterer Vorteil ist, dass das Gehäuse mit Befestigungsformelement und/oder Steckerhohlraum an kundenspezifische Anforderungen und Schnittstellen eines Fahrzeugs angepasst werden kann.

### Kurze Beschreibung der Zeichnung

Nachfolgend wird ein Ausführungsbeispiel der Erfindung unter Bezugnahme auf die begleitende Zeichnung im Detail beschrieben. In der Zeichnung zeigt:
- Figur 1: drei Ansichten in Durchsicht des erfindungsgemäßen elektronischen Bauteils gemäß einem Ausführungsbeispiel,
- Figur 2: ein erfindungsgemäßes Trägerelement gemäß Ausführungsbeispiel,
- Figur 3: ein Blechstanzband mit mehreren erfindungsgemäßen Trägerelementen gemäß Ausführungsbeispiel,
- Figur 4: drei Ansichten eines verwendeten Mikrobauteils gemäß Ausführungsbeispiel,
- Figur 5: eine mögliche Anordnung elektronischer Bauteile innerhalb des Mikrobauteils gemäß Ausführungsbeispiel,
- Figur 6: drei Schnittansichten eines Gehäuses ohne Mikrobauteil gemäß Ausführungsbeispiel,
- Figur 7: drei Ansichten des Gehäuses in Durchsicht mit montiertem Mikrobauteil gemäß Ausführungsbeispiel,
- Figur 8: eine schematische Darstellung der Montage des Mikrobauteils in das Trägerelement gemäß Ausführungsbeispiel,
- Figur 9 bis 11: drei Ansichten des Trägerelements mit montiertem Mikrobauteil gemäß Ausführungsbeispiel,
- Figur 12 bis 14: einen schematischen Ablauf zur Herstellung des Gehäuses mit einem erfindungsgemäßen Spritzgießwerkzeug gemäß Ausführungsbeispiel,
- Figur 15 und 16: einen schematischen Ablauf der Montage des Mikrobauteils gemäß Ausführungsbeispiel, und
- Figur 17 bis 19: einen schematischen Ablauf des Ausspritzens eines Hohlraums mit einem Füllmaterial gemäß Ausführungsbeispiel.

### Ausführungsform der Erfindung

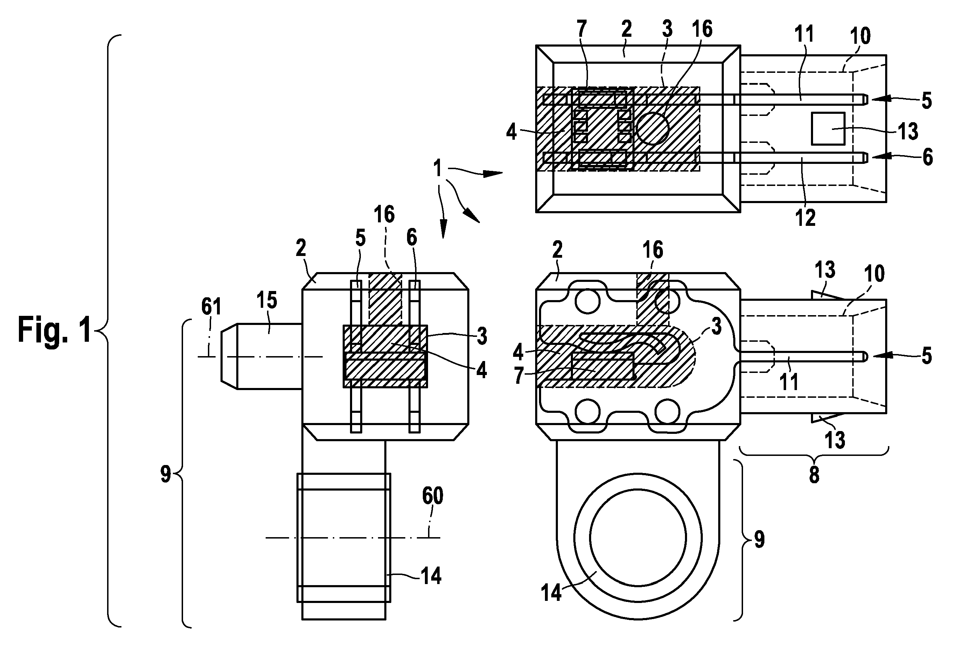

Figur 1 zeigt ein fertiges elektronisches Bauteil 1, ausgebildet als Beschleunigungssensor zur Anwendung in der Kraftfahrzeugtechnik, hergestellt nach einem erfindungsgemäßen Verfahren zur Herstellung des elektronischen Bauteils 1 gemäß Ausführungsbeispiel. Figur 1 zeigt hierzu drei verschiedene Ansichten des elektronischen Bauteils 1 in Durchsicht.

Das elektronische Bauteil 1 umfasst ein Gehäuse 2 aus Thermoplast mit einem darin ausgebildeten, seitlich offenen Hohlraum 3. Dieser Hohlraum 3 ist mit einem Füllmaterial 4, bestehend aus Silikon, ausgespritzt. In das Gehäuse 2 wurde ein erstes Trägerelement 5 parallel und beabstandet zu einem zweiten Trägerelement 6 mit eingespritzt. Das erste Trägerelement 5 und das zweite Trägerelement 6 sind jeweils metallisch und leitend. Umhüllt vom Füllmaterial 4 und kontaktiert mit dem ersten Trägerelement 5 und dem zweiten Trägerelement 6 sitzt ein Mikrobauteil 7 im Hohlraum 3 des Gehäuses 2.

Die äußere Form des Gehäuses 2 weist ein Anschlussformelement 8 und ein Befestigungsformelement 9 auf. Das Anschlussformelement 8 umfasst einen Steckerhohlraum 10, in welchen sich ein erster Anschlusspin 11 des ersten Trägerelements 5 und ein zweiter Anschlusspin 12 des zweiten Trägerelementes 6 erstreckt. Desweiteren umfasst das Anschlussformelement 8 auf der Außenseite des Gehäuses 2 eine Steckersicherung 13 in Form von zwei Rastnasen. Dieses Anschlussformelement 8 dient dazu, einen Stecker auf das Gehäuse 2 aufzusetzen und somit den ersten Anschlusspin 11 und den zweiten Anschlusspin 12 mit beispielsweise einem Kabel zu verbinden.

Das Befestigungsformelement umfasst eine eingespritzte metallische Buchse 14 sowie eine Verdrehsicherung 15, ausgebildet als zylindrischer Zapfen. Eine Achse 60 der Buchse 14 ist dabei parallel zu einer weiteren Achse 61 der Verdrehsicherung 15, so dass das elektronische Bauteil 1 mittels nur einer Schraube oder eines Bolzens verdrehsicher an einer Schnittstelle angeschraubt werden kann.

Desweiteren ist in Figur 1 zu sehen, dass im Gehäuse 2 des elektronischen Bauteils 1 ein Entlüftungskanal 16 ausgebildet ist. Dieser Entlüftungskanal 16 ist ebenfalls mit Füllmaterial 4 ausgefüllt. Dieser Entlüftungskanal 16 kann bei Ausspritzen des Hohlraums 3 mit Füllmaterial 4 vorteilhaft sein, ist jedoch nicht zwingend notwendig.

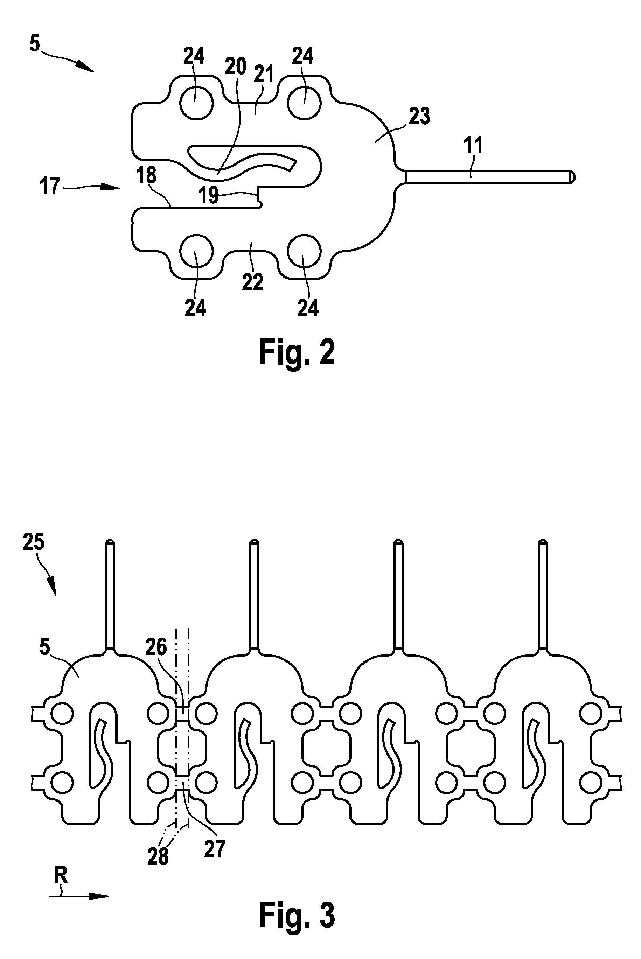

Figur 2 zeigt das erfindungsgemäße erste Trägerelement 5 gemäß Ausführungsbeispiel. Wie bereits anhand von Figur 1 aufgezeigt wurde, umfasst das elektronische Bauteil 1 sowohl ein erstes Trägerelement 5 als auch ein zweites Trägerelement 6. Diese beiden Trägerelemente 5, 6 sind parallel zueinander im elektronischen Bauteil 1 angeordnet und dienen beide zur Kontaktierung und Klemmung des Mikrobauteils 7. In Figur 2 sowie in diversen folgenden Figuren wird teilweise nur das erste Trägerelement 5 diskutiert. Es bleibt jedoch zu beachten, dass das erste Trägerelement 5 sowie das zweite Trägerelement 6 absolut identisch ausgestaltet sind und nur aus Gründen der vereinfachten Darstellung manche Figuren lediglich das erste Trägerelement 5 zeigen.

Das erste Trägerelement 5 umfasst eine Mikrobauteilaufnahme 17, einen ersten Verbindungsbereich 21, einen zweiten Verbindungsbereich 22, einen Verbindungsbogen 23 und den ersten Anschlusspin 11.

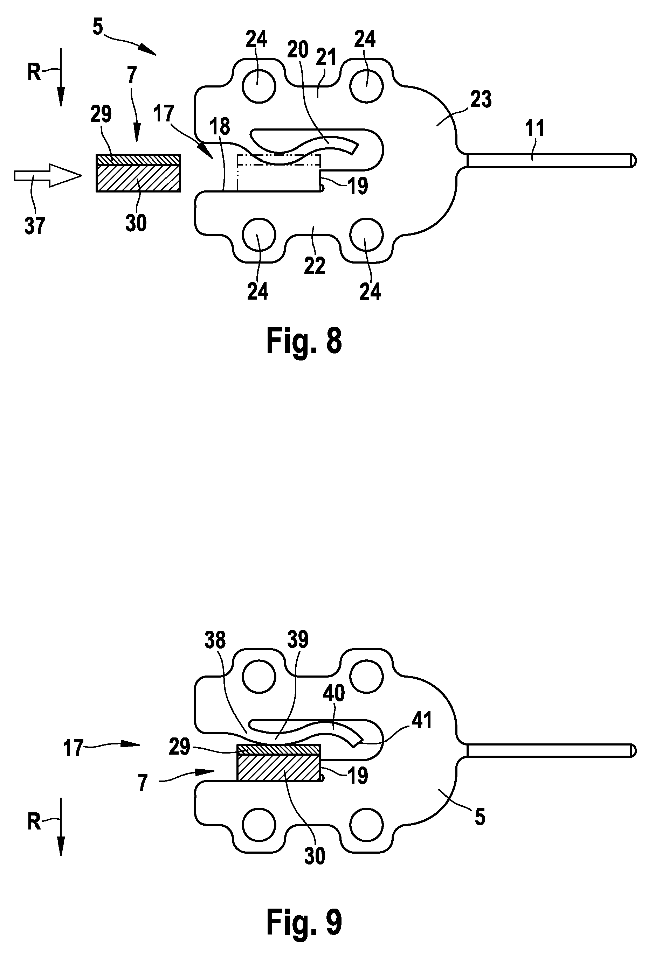

Wichtige Elemente der Mikrobauteilaufnahme 17 sind die Auflage 18, der Anschlag 19 sowie das Federelement 20. Die genaue Ausgestaltung des Federelements 20 sowie dessen Funktion zur Klemmung des Mikrobauteils 7 wird anhand der Figuren 8 bis 11 genauer erläutert. Die Auflage 18 dient sowohl zum Führen des Mikrobauteils 7 bei der Montage als auch als Gegenfläche zum Federelement 20. Das Mikrobauteil 7 wird, wie anhand der Figuren 8 bis 11 beschrieben wird, zwischen Federelement 20 und Auflage 18 eingeklemmt. Um das Mikrobauteil 7 sowohl gegenüber dem Gehäuse 2 als auch gegenüber dem Federelement 20 exakt zu positionieren, weist die Mikrobauteilauflage 17 einen Anschlag 19 auf.

Die Auflage 18 geht direkt über in den zweiten Verbindungsbereich 22. Das Federelement 20 ist verbunden mit dem ersten Verbindungsbereich 21. Der erste Verbindungsbereich 21 mit dem Federelement 20 steht dem zweiten Verbindungsbereich 22 mit der Auflage 18 gegenüber. Der erste Verbindungsbereich 21 ist mit dem zweiten Verbindungsbereich 22 über den Verbindungsbogen 23 auf eine Seite verbunden, so dass die Mikrobauteilaufnahme 17 im Wesentlichen bogenförmig ausgestaltet ist.

Der erste Verbindungsbereich 21, der zweite Verbindungsbereich 22 sowie der Verbindungsbogen 23 stellen zusammen einen Umspritzanteil des ersten Trägerelements 5 dar. Dieser Umspritzanteil kommt bei Umspritzen des Gehäuses 2 in direkten Kontakt mit dem Material des Gehäuses 2 und stellt somit die Verbindung zwischen erstemTrägerelement 5 und Gehäuse 2 dar. Um diese Verbindung noch zu verbessern, sind im ersten Verbindungsbereich 21 sowie im zweiten Verbindungsbereich 22 insgesamt vier Durchgangslöcher 24 ausgebildet, welche sich mit dem Material des Gehäuses 2 füllen. Desweiteren ist am Verbindungsbogen 23 der erste Anschlusspin 11 ausgebildet.

Figur 3 zeigt, wie die Trägerelemente 5, 6 in einem Stanzprozess aus einem Blech gefertigt werden. Durch diese Herstellungsart entsteht das in Figur 3 dargestellte Stanzband 25. Dieses Stanzband 25 ist eine Aufreihung einer Vielzahl von Trägerelementen 5, 6, welche jeweils über ein erstes abstanzbares Verbindungselement 26 und ein zweites abstanzbares Verbindungselement 27 miteinander verbunden sind. Die abstanzbaren Verbindungselemente 26, 27 erstrecken sich dabei jeweils vom ersten Verbindungsbereich 21 des einen Trägerelements 5, 6 zum zweiten Verbindungsbereich 22 des anderen Trägerelements 5, 6. Das Stanzband 25 wird vor Vereinzelung einem Bandgalvanikprozess unterzogen.

Vor der Verwendung der Trägerelemente 5, 6 im elektronischen Bauteil 1 müssen diese vereinzelt werden. Hierzu werden das erste abstanzbare Verbindungselement 26 sowie das zweite abstanzbare Verbindungselement 27 entlang der eingezeichneten Trennlinie 28 abgestanzt.

Desweiteren ist anhand des in Figur 3 dargestellten Stanzbandes 25 die Ebene des Bleches, aus welchem die Trägerelemente 5, 6 hergestellt wurden, gut zu erkennen. Dadurch wird auch deutlich, dass das Federelement 20 des ersten Trägerelements 5 sich in dieser Ebene des Bleches befindet und somit eine Federkraft zur Klemmung und Kontaktierung des Mikrobauteils 7 in einer Richtung R aufbringen kann.

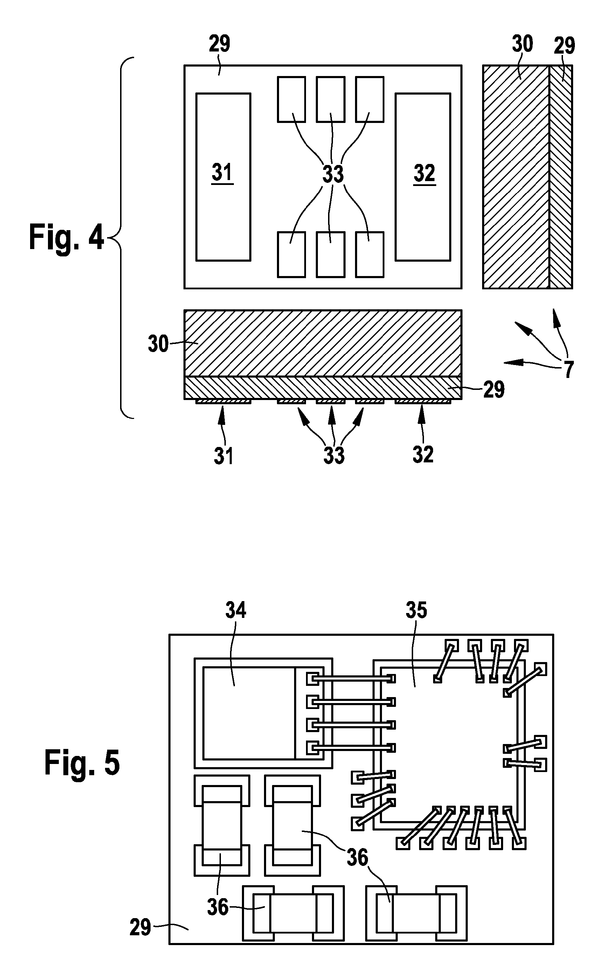

Die Figuren 4 und 5 zeigen das Mikrobauteil 7, wie es im Ausführungsbeispiel zur Anwendung kommt. Dabei zeigt Figur 4 eine Ansicht des Mikrobauteils 7 von unten sowie zwei seitliche Ansichten. Figur 5 zeigt das Mikrobauteil 7 ohne Umhüllung.

Das Mikrobauteil 7 umfasst eine Leiterplatte 29 mit darauf angeordnetem mikroelektromechanischem Sensor (MEMS) 34, anwendungsspezifischem Schaltkreis (ASIC) 35 und vier Mikrochips (SMD) 36. Der mikroelektromechanische Sensor 34, der anwendungsspezifische Schaltkreis 35 sowie die Mikrochips 36 sind vollständig mit einer Umhüllung 30 (Mold Compound) umgossen. Auf einer Unterseite der Leiterplatte 29 ist ein erster Kontaktpad 31, ein zweiter Kontaktpad 32 sowie sechs Programmierpads 33 ausgebildet.

Das Mikrobauteil 7 wurde in einer großen Matrix hergestellt, wobei eine Vielzahl gleicher Mikrobauteile 7 nebeneinander bestückt und umhüllt wurden. Anschließend wurden die einzelnen Mikrobauteile 7 durch Sägen oder Lasernutzentrennung vereinzelt und zu exakten Quadern geschnitten.

Die sich auf der Unterseite befindenden Programmierpads 33 werden bei der Herstellung bzw. bei der Überprüfung des Mikrobauteils 7 genutzt. Im Rahmen des elektronischen Bauteils 1 sind das erste Kontaktpad 31 sowie das zweite Kontaktpad 32 entscheidend. Das erste Kontaktpad 31 wird mit dem ersten Trägerelement 5 kontaktiert. Das zweite Kontaktpad 32 wird mit dem zweiten Trägerelement 6 kontaktiert. Somit steht dann im fertigen elektronischen Bauteil der erste Anschlusspin 11 mit dem ersten Kontaktpad 31 in Verbindung. Der zweite Anschlusspin 12 steht mit dem zweiten Kontaktpad 32 in Verbindung.

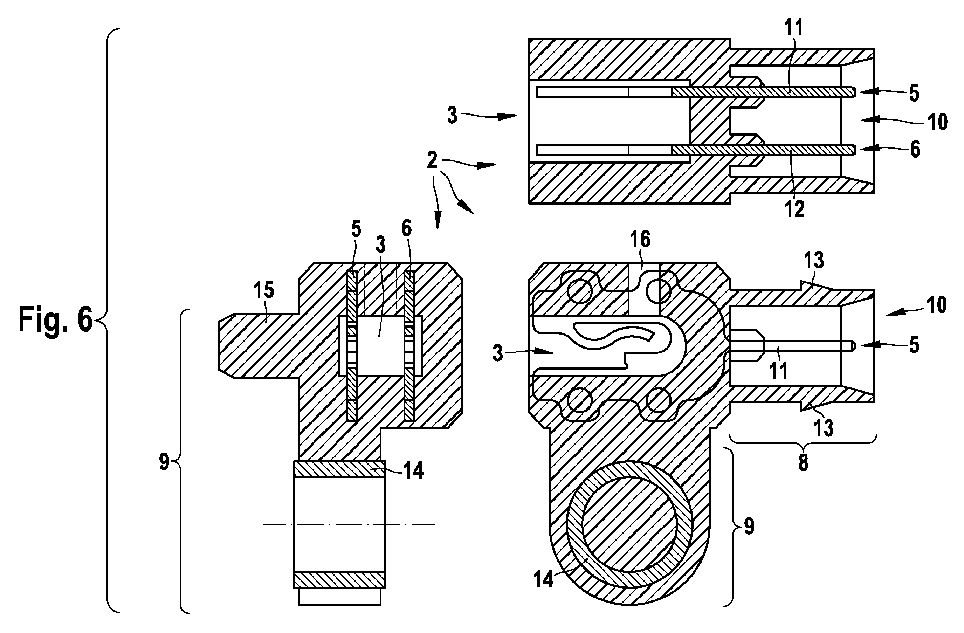

Figur 6 zeigt drei verschiedene Schnittansichten des Gehäuses 2 mit eingespritztem ersten Trägerelement 5 und eingespritztem zweiten Trägerelement 6. Dabei ist gut zu sehen, wie der Hohlraum 3 vom Material des Gehäuses 2 freibleibt. Ebenso bleibt ein Entlüftungskanal 16 frei, welcher einen hinteren Bereich des Hohlraums 3 mit einer Außenseite des Gehäuses 2 verbindet. In den Steckerhohlraum 10 erstrecken sich der erste Anschlusspin 11 sowie der zweite Anschlusspin 12, welche den elektrischen Kontakt über den ersten Kontakpad 31 und den zweiten Kontaktpad 32 zum Mikrobauteil ermöglichen.

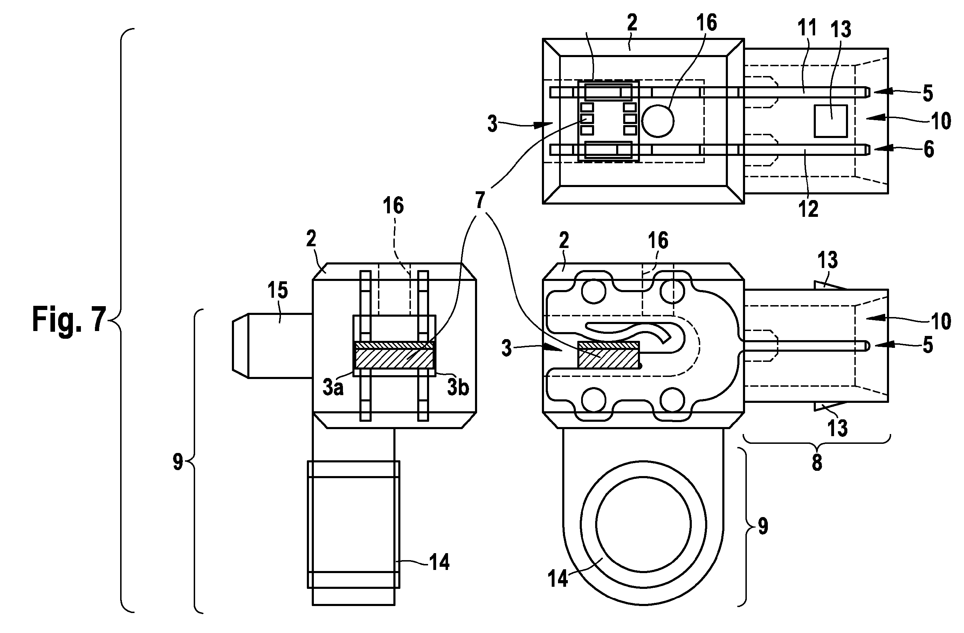

Figur 7 zeigt drei Ansichten in Durchsicht des Gehäuses 2 mit eingespritztem ersten Trägerelement 5 und eingespritztem zweiten Trägerelement 6 sowie mit fertig montiertem Mikrobauteil 7, jedoch noch vor Ausspritzen des Hohlraums 3 mit Füllmaterial 4. Dabei ist gut zu sehen, wie das Mikrobauteil 7 sowohl auf dem ersten Trägerelement 5 als auch auf dem zweiten Trägerelement 6 zu liegen kommt. Die genaue Positionierung des Mikrobauteils 7 innerhalb des ersten Trägerelements 5 und des zweiten Trägerelements 6 wird anhand der folgenden Figuren 8 bis 11 noch genauer erläutert. In Figur 7 ist des Weiteren zu sehen, dass der Hohlraum 3 eine erste Seitenwand 3a und eine zweite Seitenwand 3b aufweist. Die erste Seitenwand 3a und die zweite Seitenwand 3b stoßen annähernd an das Mikrobauteil 7, so dass das Mikrobauteil 7 seitlich durch den Hohlraum 3 geführt wird und relativ exakt zum Gehäuse 2 positioniert werden kann.

Figur 8 zeigt in schematischer Ansicht die Montage des Mikrobauteils 7 in die Mikrobauteilaufnahme 17 des ersten Trägerelements 5. Wie anhand der Figur 7 bereits verdeutlicht wurde, wird selbstverständlich das Mikrobauteil 7 gleichzeitig in das erste Trägerelement 5 und das zweite Trägerelement 6 montiert. Der einfacheren Darstellung halber ist in Figur 8 jedoch nur das erste Trägerelement 5 gezeigt. Desweiteren wurde in Figur 8 das das erste Trägerelement 5 umgebende Gehäuse 2 ausgeblendet.

Der in Figur 8 dargestellte Pfeil deutet eine Montagerichtung 37 an. In dieser Montagerichtung 37 wird das Mikrobauteil 7 in die Mikrobauteilaufnahme 17 eingeschoben. Die gestrichelte Darstellung des fertig montierten Mikrobauteils 7 in Figur 8 deutet die Endlage des Mikrobauteils 7 an. Dabei ist eine Überschneidung des Federelements 20 mit der theoretischen Endlage des Mikrobauteils 7 eingezeichnet. Diese Überschneidung deutet den Federweg des Federelements 20 an. Da sich das Federelement 20 um diesen Federweg verformt, kann das Federelement 20 eine Federkraft entlang der Richtung R auf das Mikrobauteil 7 auswirken. Dadurch wird das Mikrobauteil 7 zwischen Federelement 20 und Auflage 18 eingeklemmt und gleichzeitig kontaktiert.

Die Figuren 9 bis 11 zeigen nun wiederum unter Ausblendung des zweiten Trägerelements 6 und des Gehäuses 2 die letztendliche Lage des Mikrobauteils 7 im ersten Trägerelement 5 bzw. in der Mikrobauteilaufnahme 17. Das Federelement 20 ist in den Darstellungen gemäß Figuren 9 bis 11 deformiert dargestellt und bewirkt somit eine Federkraft entlang der Richtung R auf das Mikrobauteil 7.

Wie anhand Figur 9 genauer verdeutlicht wurde, umfasst das Federelement 20 ein festes Ende 38, verbunden mit dem ersten Verbindungsbereich 21, einen ersten Bogen 39, einen zweiten Bogen 40 sowie ein loses bzw. freies Ende 41. Der erste Bogen 39 ist dem Mikrobauteil 7 und der Auflage 18 zugewandt. Ferner geht der erste Bogen 39 direkt über in den zweiten Bogen 40. Dieser zweite Bogen 40 ist dem ersten Bogen 39 entgegengebogen und weist somit einen dem ersten Verbindungsbereich 21 zugewandten Bogen auf. Der zweite Bogen 40 ist an einer Seite mit dem ersten Bogen 39 verbunden bzw. geht in diesen über. An der anderen Seite endet der zweite Bogen 40 mit dem freien Ende 41 des Federelements 20.

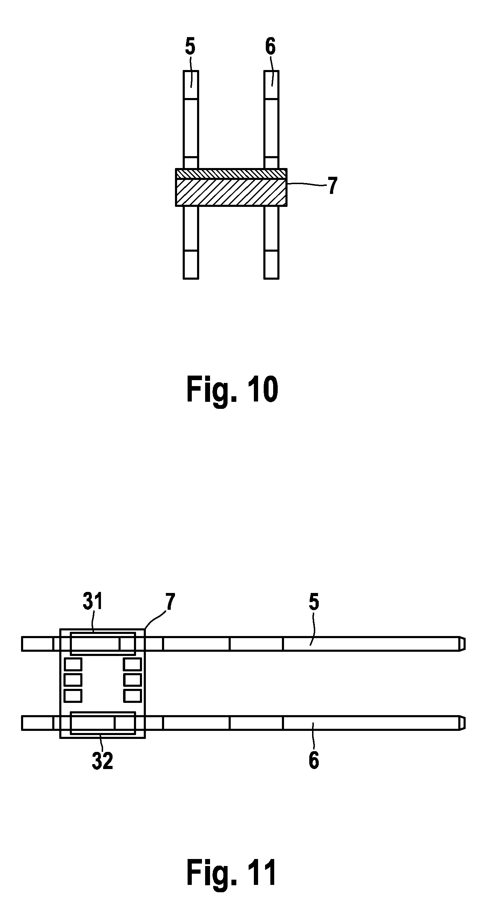

Wie die Figur 9 zeigt, liegt bei montiertem Mikrobauteil 7 der erste Bogen 39 auf dem Mikrobauteil 7 auf, wohingegen der zweite Bogen 40 am oberen Verbindungsbereich 21 anliegt. Dadurch, dass die Position des montierten Mikrobauteils 7 durch den Anschlag 19 sowie durch die seitliche Führung der Seitenwände 3a und 3b definiert ist, befindet sich der erste Bogen 39 an exakt definierter Stelle des Mikrobauteils 7, nämlich am ersten Kontaktpad 31. Durch diese exakte Positionierung ist nicht nur das Festklemmen des Mikrobauteils 7 in der Mikrobauteilaufnahme 17 gewährleistet, sondern auch die genaue Kontaktierung des ersten Trägerelements 5 mit dem ersten Kontaktpad 31 und des zweiten Trägerelements 6 mit dem zweiten Kontaktpad 32. Dies verdeutlicht nochmals die Draufsicht gemäß Figur 11.

Es wurde nun gezeigt, wie die Trägerelemente 5, 6 des elektronischen Bauteils 1 auf einfache und effiziente Weise hergestellt werden können. Die Federelemente 20 der Trägerelemente 5, 6 ermöglichen eine Festklemmung sowie Kontaktierung des Mikrobauteils 7 ohne die Verwendung von Lötstellen, und insbesondere ohne die Verwendung bleihaltiger Lote. Die endgültige Fixierung des Mikrobauteils 7 sowie dessen dämpfungsfreie und isolierte Lagerung wurde erst nach Herstellung des Gehäuses durch Einspritzen des Füllmaterials 4 realisiert. Dadurch ist es möglich, das Gehäuse mit den üblichen hohen Drücken und Temperaturen zu fertigen, ohne dass das Füllmaterial 4 oder das Mikrobauteil 7 beschädigt werden. All diese Vorteile werden auch bei der nachfolgenden Beschreibung eines erfindungsgemäßen Spritzgießwerkzeugs 42, wie es gemäß Ausführungsbeispiel verwendet wird, nochmals verdeutlicht.

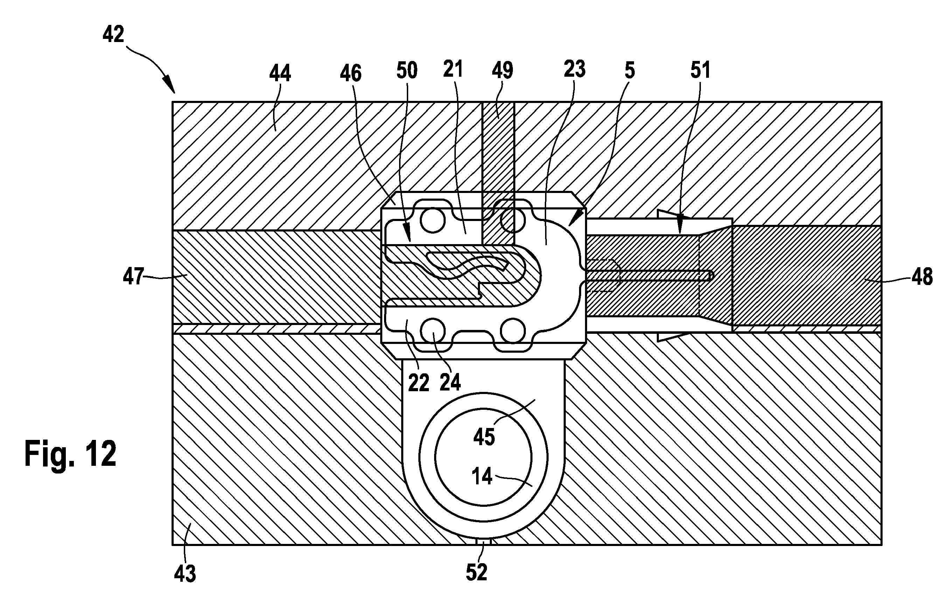

Die Figuren 12 bis 14 zeigen das erfindungsgemäße Spritzgießwerkzeug 42, wie es gemäß Ausführungsbeispiel zur Anwendung kommt, sowie den Ablauf des Herstellungsverfahrens mit dem Spritzgießwerkzeug 42 gemäß Ausführungsbeispiel.

Wie Figur 12 verdeutlicht, besteht das Spritzgießwerkzeug 42 aus einem ersten Werkzeugteil 43 und einem zweiten Werkzeugteil 44. In geschlossenem Zustand, wie er in Figur 12 dargestellt ist, bilden eine erste Spritzgießkavität 45, ausgebildet im ersten Werkzeugteil 43, und eine zweite Spritzgießkavität 46, ausgebildet im zweiten Werkzeugteil 44, zusammen die inverse Form des Gehäuses 2.

Im zweiten Werkzeugteil 44 sind des Weiteren ein Hohlraumschieber 47, ein Steckerhohlraumschieber 48 sowie ein Entlüftungskanalhohlraumschieber 49 angeordnet. Der Hohlraumschieber 47 umfasst ein hohlraumformgebendes Element 50. Dieses hohlraumformgebendes Element 50 entspricht exakt dem Hohlraum 3, wie er bei Spritzen des Gehäuses 2 frei bleiben soll, um die Montage des Mikrobauteils 7 zu ermöglichen. Dieser Hohlraumschieber 47 mit seinem hohlraumformgebenden Element 50 ermöglicht es insbesondere, dass die Mikrobauteilaufnahme 17 inklusive Federelement 20, Anschlag 19 und Auflage 18 vom Material des Gehäuses 2 beim Spritzgießvorgang frei bleibt.

Der Steckerhohlraumschieber 48 umfasst ein steckerhohlraumformgebendes Element 51. Die Kontur dieses steckerhohlraumformgebenden Elements 51 entspricht dem Steckerhohlraum 10 und gewährleistet, dass der erste Anschlusspin 11 sowie der zweite Anschlusspin 12 frei vom Material des Gehäuses 2 bleiben. Der Entlüftungskanalhohlraumschieber 49 definiert den Entlüftungskanal 16, welcher zur sicheren Ausspritzung des Hohlraums 3 mit Füllmaterial 4 später benötigt wird.

Das Befestigungsformelement 9 ist vorteilhafterweise in dem unten liegenden ersten Werkzeugteil 43 ausgebildet. Wie sich anhand der folgenden Figuren noch zeigen wird, wird dieses erste Werkzeugteil 43 über den gesamten Herstellungsprozess als Halterung oder Befestigung des Gehäuses 2 verwendet. Dabei dient das Befestigungsformelement 9 während der Herstellung als formschlüssige Verbindung zwischen Gehäuse 2 und erstem Werkzeugteil 43.

Desweiteren wird vor Einspritzen des Gehäuses 2 in das Spritzgießwerkzeug 43 die Buchse 14 in die erste Spritzgießkavität 45 eingelegt.

Nach Einlegen des ersten Trägerelements 5, des zweiten Trägerelements 6 und der Buchse 14, sowie nach Schließen des Hohlraumschiebers 47, des Steckerhohlraumschiebers 48 und des Entlüftungskanalhohlraumschiebers 49 wird flüssiger Thermoplast über eine Angussöffnung 42 in die erste Spritzgießkavität 45 und die zweite Spritzgießkavität 46 eingespritzt, wodurch das Gehäuse 2 entsteht.

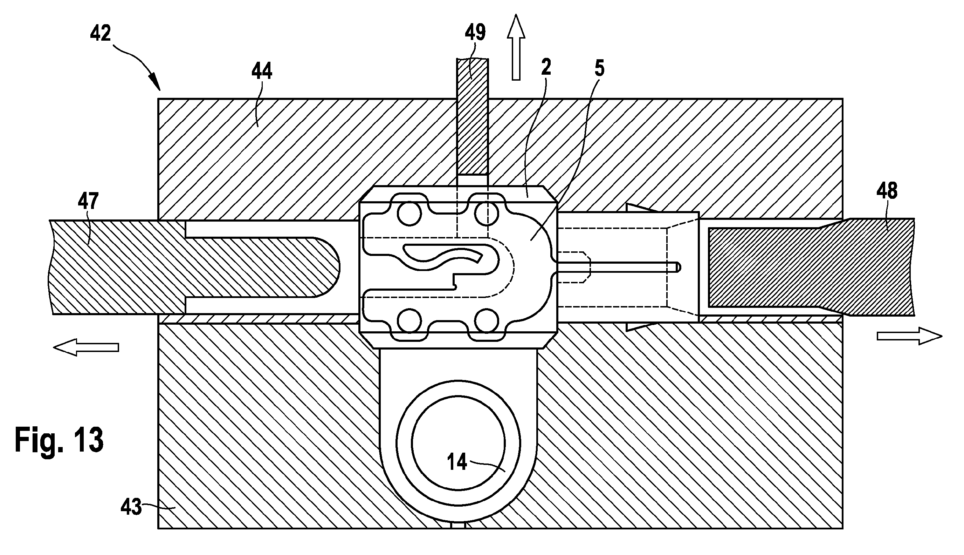

Figur 13 zeigt, wie nach Erstarren des Gehäuses 2 der Hohlraumschieber 47, der Steckerhohlraumschieber 48 und der Entlüftungskanalhohlraumschieber 49 aus dem Gehäuse 2 herausgezogen werden.

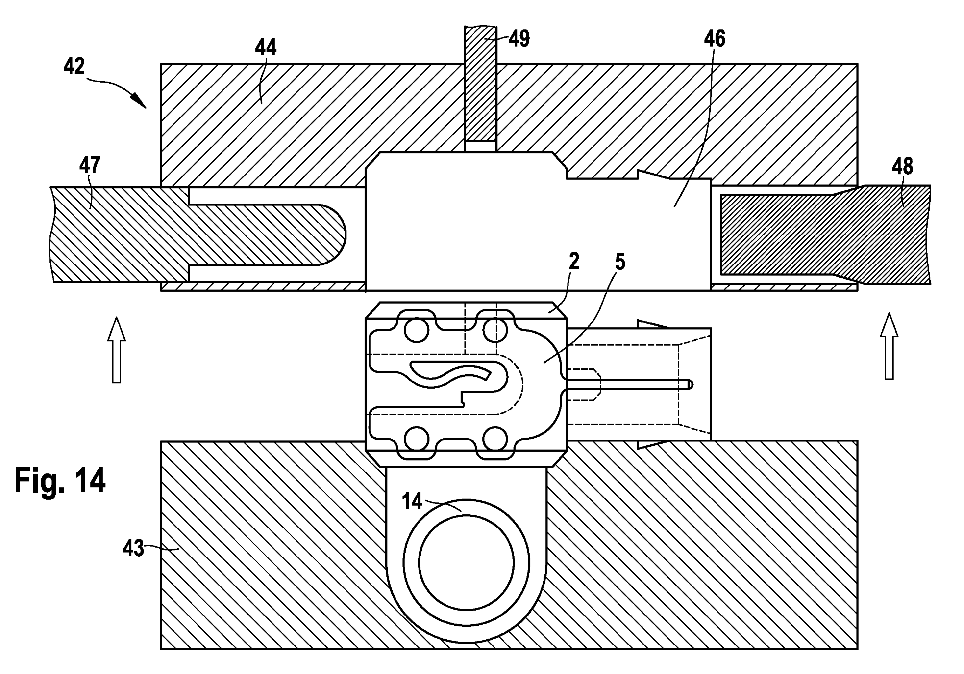

Gemäß der Darstellung in Figur 14 wird daraufhin der gesamte zweite Werkzeugteil 44 vom Gehäuse 2 beabstandet. Das Gehäuse 2 bleibt dabei jedoch in der ersten Spritzgießkavität 45 des ersten Gehäuseteils 43 liegen, so dass das erste Werkzeugteil 43 im folgenden Herstellungsprozess weiterhin als Halterung bzw. Befestigung des Gehäuses 2 dient.

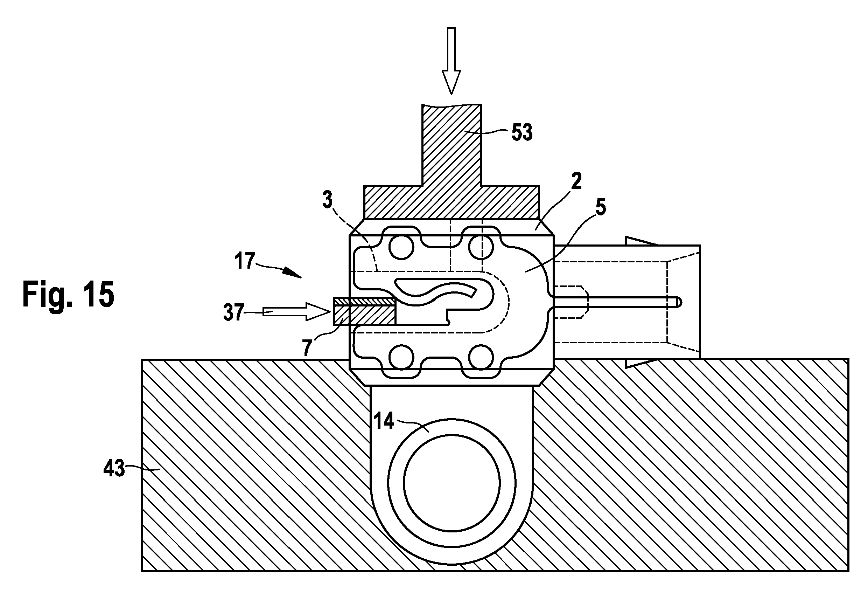

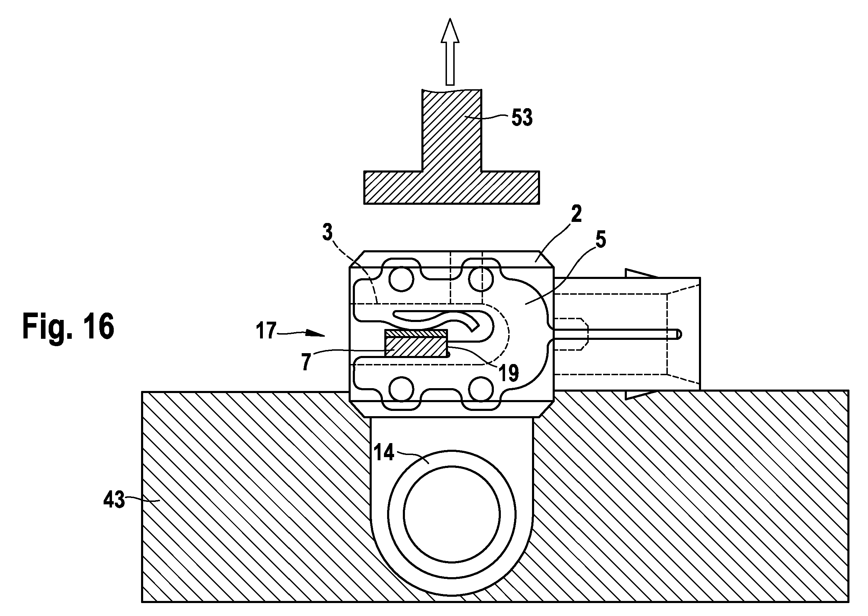

Die Figuren 15 und 16 zeigen, wie in einem nächsten Verfahrensschritt das Mikrobauteil 7 entlang der Montagerichtung 37 in die Mikrobauteilaufnahme 17 eingeführt wird. Hierzu wird ein Stempel 43 auf das Gehäuse 2 abgesenkt, so dass das Gehäuse fest im ersten Werkzeugteil 43 verbleibt. Daraufhin wird das Mikrobauteil 7 entlang der Montagerichtung 37 in den Hohlraum 3 eingeschoben, wodurch das Mikrobauteil 7 durch die Federelemente 20 sowohl geklemmt als auch kontaktiert wird.

Figur 16 zeigt das fertig positionierte Mikrobauteil 7 sowie das Zurückfahren des Stempels 53.

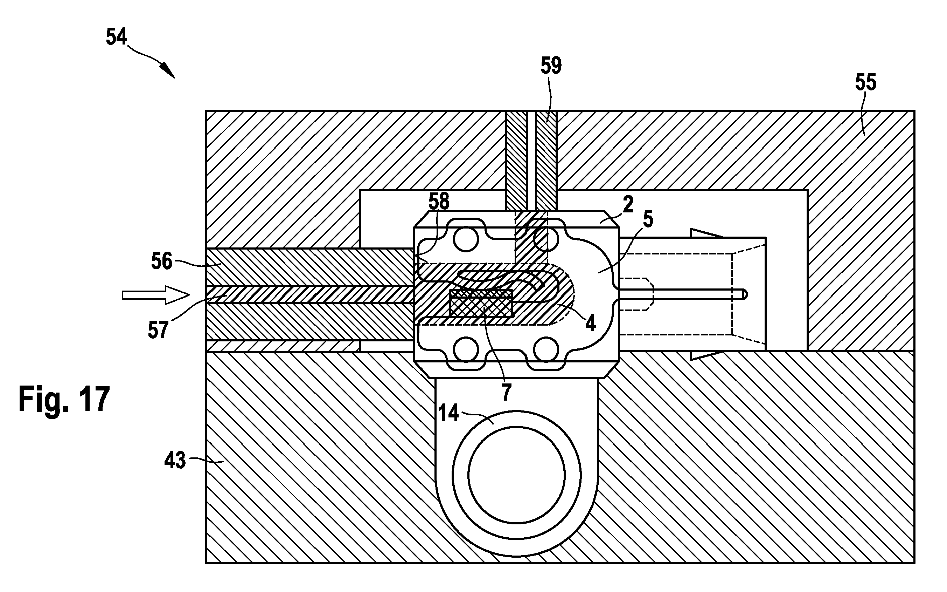

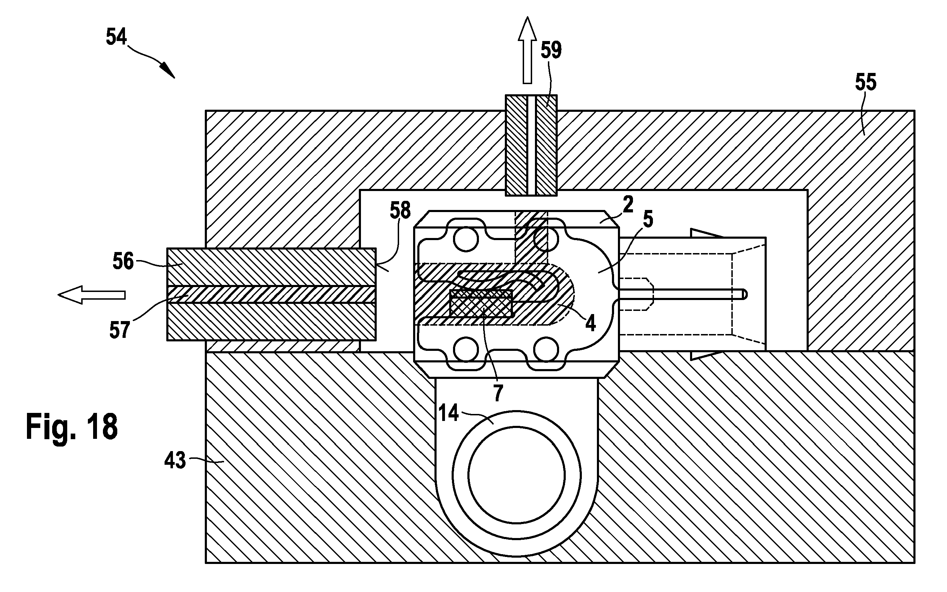

Die Figuren 17 und 18 zeigen das Ausspritzen des Hohlraums 3 mit dem Füllmaterial 4. Dabei kommt ein Füllmaterial-Spritzwerkzeug 54 zum Einsatz. Dieses Füllmaterial-Spritzwerkzeug 45 besteht aus einem Träger 55, in welchem ein Einspritzschieber 56 sowie ein Entlüftungskanalschieber 59 angeordnet sind. In den Einspritzschieber 56 ist ein Spritzkanal 57 eingearbeitet. Desweiteren umfasst der Einspritzschieber 56 eine dem Gehäuse 2 zugewandte dichte Anlagefläche 58, um den Spritzkanal 57 dicht mit dem Hohlraum 3 zu verbinden.

Das Gehäuse 2 mit montiertem Mikrobauteil 7 verbleibt auch bei Einspritzen des Füllmaterials 4 im ersten Werkzeugteil 43. Auf dieses erste Werkzeugteil 43 wird der Träger 55 des Füllmaterial-Spritzwerkzeugs 54 abgesenkt. Daraufhin werden der Einspritzschieber 56 sowie der Entlüftungskanalschieber 59 an das Gehäuse 2 angesetzt. Über den Einspritzkanal 57 wird der Hohlraum 3 mit Füllmaterial 4 gefüllt. Wie in Figur 18 gezeigt, werden daraufhin der Einspritzschieber 56 sowie der Entlüftungskanalschieber 59 vom Gehäuse 2 zurückgezogen.

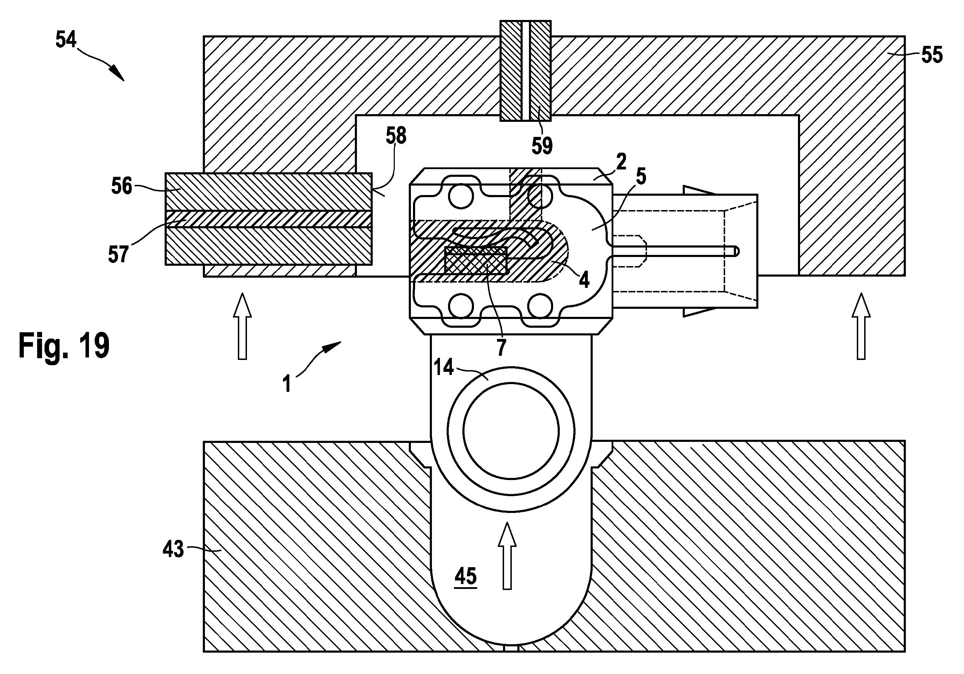

In einem letzten Verfahrensschritt gemäß Figur 19 wird das gesamte Füllmaterial-Spritzwerkzeug 54 sowie das erste Werkzeugteil 43 vom nun fertigen elektronischen Bauteil 1 entfernt. Das elektronische Bauteil kann nun entgratet und von Angüssen befreit werden.

Die Figuren 12 bis 19 zeigen, wie das elektronische Bauteil mit dem Spritzgießwerkzeug 42 vorteilhaft herzustellen ist. Dabei wurde verdeutlicht, wie es möglich ist, den äußeren Anteil, nämlich das Gehäuse 2, zuerst zu fertigen, daraufhin erst das empfindliche Mikrobauteil 7 zu montieren und in einem letzten Schritt das empfindliche Mikrobauteil 7 mit einem Füllmaterial 4 zu umhüllen und somit fest im Gehäuse 2 zu fixieren. Während der gesamten Herstellung verbleibt dabei das Gehäuse 2 im ersten Werkzeugteil 43 und muss somit nicht in verschiedene Aufnahmen umgesetzt werden. Das erste Werkzeugteil 43 befindet sich hierzu vorteilhafterweise auf einem Drehtisch mit vier Positionen, wobei die Positionen wie folgt verteilt sind: an erster Position erfolgt der Spritzguss des Gehäuses 2, an zweiter Position wird das Mikrobauteil 7 in die Mikrobauteilaufnahme 17 eingeschoben, an dritter Position wird der Hohlraum 3 mit Füllmaterial 4 ausgespritzt und an vierter Position erfolgt die Entnahme des fertigen elektronischen Bauteils 1 sowie die erneute Bestückung des Spritzgießwerkzeugs 42 mit dem ersten Trägerelement 5, dem zweiten Trägerelement 6 sowie der Buchse 14 für die Herstellung des darauffolgenden elektronischen Bauteils 1.

## Patentansprüche

1. Verfahren zur Herstellung eines elektronischen Bauteils (1), umfassend die in folgender Reihenfolge ausgeführten Schritte:
- Bereitstellen zumindest eines Trägerelementes (5, 6), umfassend eine zur Kontaktierung zumindest eines Mikrobauteils (7) ausgebildete Mikrobauteilaufnahme (17),
- Umspritzen des Trägerelementes (5, 6) mit einem Gehäuse (2), wobei die Mikrobauteilaufnahme (17) in einem zumindest einseitig offenen Hohlraum (3) des Gehäuses (2) angeordnet ist,
- Einführen des zumindest einen Mikrobauteils (7) in die Mikrobauteilaufnahme (17) im Hohlraum (3), um das zumindest eine Mikrobauteil (7) mit dem Trägerelement (5, 6) zu kontaktieren, und
- Ausspritzen des Hohlraums (3) mit einem Füllmaterial (4), um das kontaktierte zumindest eine Mikrobauteil (7) im Gehäuse (2) und in der Mikrobauteilaufnahme (17) zu fixieren.

2. Verfahren nach Anspruch 1, **dadurch gekennzeichnet, dass** das elektronische Bauteil (1) zwei Trägerelemente (5, 6) umfasst, und das Mikrobauteil (7) zwei Kontaktpads (31, 32) umfasst, welche jeweils mit einer Mikrobauteilaufnahme (17) eines Trägerelements (5, 6) kontaktiert werden, wobei die beiden Mikrobauteilaufnahmen (17) der beiden Trägerelemente (5, 6) gemeinsam in dem Hohlraum (3) angeordnet sind.

3. Verfahren nach einem der vorhergehenden Ansprüche, **dadurch gekennzeichnet, dass** der Hohlraum (3) größer ist als das Mikrobauteil (7), so dass das Mikrobauteil (7), mit Ausnahme von Berührungsstellen von dem Mikrobauteil (7) mit dem Trägerelement (5, 6) und/oder Gehäuse (2), vom Füllmaterial (4) vollständig umhüllt wird.

4. Verfahrenen nach einem der vorhergehenden Ansprüche, **dadurch gekennzeichnet, dass** beim Einführen des Mikrobauteils (7) in die Mikrobauteilaufnahme (17) das Mikrobauteil (7) in der Mikrobauteilaufnahme (17) geklemmt wird.

5. Verfahren nach einem der vorhergehenden Ansprüche, **gekennzeichnet durch** Verwendung eines mehrteiligen Spritzgießwerkzeugs (42), umfassend ein erstes Werkzeugteil (43) mit einer ersten Spritzgießkavität (45), ein zweites Werkzeugteil (44) mit einer zweiten Spritzgießkavität (46), und einen Hohlraumschieber (47), wobei die erste Spritzgießkavität (45) und die zweite Spritzgießkavität (46) zusammen eine äußere Form des Gehäuses (2) bestimmen, und wobei während des Umspritzens des Trägerelementes (5, 6) mit dem Gehäuse (2) sich der Hohlraumschieber (47) in die erste und/oder zweite Spritzgießkavität (45, 46) erstreckt, um den Hohlraum (3) zu definieren.

6. Verfahren nach Anspruch 5, **dadurch gekennzeichnet, dass** zum Einführen des Mikrobauteils (7) in die Mikrobauteilaufnahme (17) das Gehäuse (2) im ersten Werkzeugteil (43) verbleibt, und der zweite Werkzeugteil (44) und der Hohlraumschieber (47) vom Gehäuse (2) beabstandet werden.

7. Verfahren nach einem der Ansprüche 5 oder 6, **dadurch gekennzeichnet, dass** zum Ausspritzen des Hohlraums (3) mit dem Füllmaterial (4) das Gehäuse (2) im ersten Werkzeugteil (43) verbleibt und über einen Einspritzschieber (56) das Füllmaterial (4) in den Hohlraum (3) gespritzt wird.

8. Verfahren nach einem der Ansprüche 5 bis 7, **dadurch gekennzeichnet, dass** die erste Spritzgießkavität (45) ein Befestigungsformelement (9) des Gehäuses (2) bestimmt.

9. Verfahren nach einem der Ansprüche 5 bis 8, **dadurch gekennzeichnet, dass** der zweite Werkzeugteil (44) einen Steckerhohlraumschieber (48) umfasst, wobei während des Umspritzens des Trägerelementes (5, 6) mit dem Gehäuse (2) der Steckerhohlraumschieber (48) einen Steckerhohlraum (10) um einen Anschlusspin (11, 12) des Trägerelementes (5, 6) herum bestimmt.

10. Trägerelement (5, 6) ausgebildet zur Herstellung eines elektronischen Bauteils (1) nach einem Verfahren gemäß einem der vorhergehenden Ansprüche, umfassend
- die Mikrobauteilaufnahme (17) mit einem zur Kontaktierung des Mikrobauteils (7) ausgebildeten Federelement (20),
- einen zum direkten Umspritzen mit dem Gehäuse (2) ausgebildeten Umspritzanteil, um das Trägerelement (5, 6) im Gehäuse (2) zu fixieren, und
- einen Anschlusspin (11, 12), welcher dazu ausgebildet ist, um von Gehäuse (2) und Füllmaterial (4) frei zu bleiben.

11. Trägerelement nach Anspruch 10, **dadurch gekennzeichnet, dass** das Trägerelement (5, 6) aus einem Blech gestanzt ist und das Federelement (20) derart ausgebildet ist, dass es das Mikrobauteil (7) in einer Richtung (R) parallel zur Ebene des Bleches beaufschlagt.

12. Trägerelement nach einem der Ansprüche 10 oder 11, **dadurch gekennzeichnet, dass** die Mikrobauteilaufnahme (17) einen Anschlag (19) umfasst, um das Mikrobauteil (7) exakt zu positionieren.

13. Sensor zur Anwendung in einem Kraftfahrzeug, umfassend ein elektronisches Bauteil (1) hergestellt nach einem Verfahren gemäß einem der Ansprüche 1 bis 9, mit einem Trägerelement (5, 6) gemäß einem der Ansprüche10 bis 12, wobei das Mikrobauteil (7) einen mikroelektromechanischen Sensor (34) umfasst.

## Claims

1. Method for producing an electronic component (1), comprising the steps performed in the following sequence:
- providing at least one carrier element (5, 6), comprising a microcomponent receptacle (17) designed for establishing electrical contact with at least one microcomponent (7),
- encapsulating the carrier element (5, 6) with a housing (2) by injection moulding, the microcomponent receptacle (17) being arranged in a cavity (3) of the housing (2) that is open at least on one side,
- introducing the at least one microcomponent (7) into the microcomponent receptacle (17) in the cavity (3) in order to establish electrical contact between the at least one microcomponent (7) and the carrier element (5, 6), and
- injecting a filler material (4) into the cavity (3) in order to fix the contacted at least one microcomponent (7) in the housing (2) and in the microcomponent receptacle (17).

2. The method according to Claim 1, **characterized in that** the electronic component (1) comprises two carrier elements (5, 6), and the microcomponent (7) comprises two contact pads (31, 32), which are each in electrical contact with a microcomponent receptacle (17) of a carrier element (5, 6), the two microcomponent receptacles (17) of the two carrier elements (5, 6) being situated together in the cavity (3).

3. Method according to one of the preceding claims, **characterized in that** the cavity (3) is larger than the microcomponent (7), so that the microcomponent (7) is completely encased by the filler material (4), with the exception of points of contact of the microcomponent (7) with the carrier element (5, 6) and/or the housing (2).

4. Method according to one of the preceding claims, **characterized in that**, when the microcomponent (7) is introduced into the microcomponent receptacle (17), the microcomponent (7) is clamped in the microcomponent receptacle (17).

5. Method according to one of the preceding claims, **characterized by** use of a multi-part injection moulding tool (42), comprising a first tool part (43) with a first injection moulding cavity (45), a second tool part (44) with a second injection moulding cavity (46), and a cavity slide (47), wherein the first injection moulding cavity (45) and the second injection moulding cavity (46) together determine an outer shape of the housing (2), and wherein, during the encapsulation of the carrier element (5, 6) with the housing (2), the cavity slide (47) extends into the first and/or second injection moulding cavity (45, 46) in order to define the cavity (3).

6. Method according to Claim 5, **characterized in that**, for introducing the microcomponent (7) into the microcomponent receptacle (17), the housing (2) remains in the first tool part (43), and the second tool part (44) and the cavity slide (47) are set apart from the housing (2).

7. Method according to either of Claims 5 and 6, **characterized in that**, for injecting the filler material (4) into the cavity (3), the housing (2) remains in the first tool part (43) and the filler material (4) is injected into the cavity (3) via an injection slide (56).

8. Method according to one of Claims 5 to 7, **characterized in that** the first injection moulding cavity (45) determines a fastening form element (9) of the housing (2).

9. Method according to one of Claims 5 to 8, **characterized in that** the second tool part (44) comprises a plug cavity slide (48), wherein, during the encapsulation of the carrier element (5, 6) with the housing (2), the plug cavity slide (48) determines a plug cavity (10) around a connecting pin (11, 12) of the carrier element (5, 6).

10. Carrier element (5, 6) designed for producing an electronic component (1) by a method according to one of the preceding claims, comprising:
- the microcomponent receptacle (17) with a spring element (20) designed for establishing electrical contact with the microcomponent (7),
- an encapsulating component designed for direct encapsulation with the housing (2) by injection moulding, in order to fix the carrier element (5, 6) in the housing (2), and
- a connecting pin (11, 12), which is designed to remain free of the housing (2) and filler material (4).

11. Carrier element according to Claim 10, **characterized in that** the carrier element (5, 6) is punched from a metal sheet and the spring element (20) is designed in such a way that it acts upon the microcomponent (7) in a direction (R) parallel to the plane of the metal sheet.

12. Carrier element according to either of Claims 10 and 11, **characterized in that** the microcomponent receptacle (17) comprises a stop (19), in order to position the microcomponent (7) exactly.

13. Sensor for use in a motor vehicle, comprising an electronic component (1) produced by a method according to one of Claims 1 to 9, with a carrier element (5, 6) according to one of Claims 10 to 12, wherein the microcomponent (7) comprises a microelectromechanical sensor (34).

## Revendications

1. Procédé de fabrication d'un composant électronique (1), comprenant les étapes réalisées dans l'ordre suivant :
- produire au moins un élément de support (5, 6), comprenant un logement pour microcomposant (17) conçu pour la mise en contact d'au moins un microcomposant (7).
- enrober l'élément de support (5, 6) avec un boîtier (2), dans lequel le logement pour microcomposant (17) est disposé dans un espace creux (3) ouvert au moins d'un côté du boîtier (2),
- introduire l'au moins un microcomposant (7) dans le logement pour microcomposant (17) dans l'espace creux (3) pour mettre en contact l'au moins un microcomposant (7) avec l'élément de support (5, 6), et
- remplir par injection l'espace creux (3) avec un matériau de remplissage (4) pour fixer l'au moins un microcomposant (7) mis en contact dans le boîtier (2) et dans le logement pour microcomposant (17).

2. Procédé selon la revendication 1, **caractérisé en ce que** le composant électronique (1) comprend deux éléments de support (5, 6), et **en ce que** le microcomposant (7) comprend deux plots de contact (31, 32), qui sont respectivement mis en contact avec un logement pour microcomposant (17) d'un élément de support (5, 6), dans lequel les deux logements pour microcomposant (17) des deux éléments de support (5, 6) sont disposés ensemble dans l'espace creux (3).

3. Procédé selon l'une quelconque des revendications précédentes, **caractérisé en ce que** l'espace creux (3) est plus grand que le microcomposant (7), de manière à ce que le microcomposant (7), à l'exception de points de contact du microcomposant (7) avec l'élément de support (5, 6) et/ou le boîtier (2), soit entièrement enveloppé par le matériau de remplissage (4).

4. Procédé selon l'une quelconque des revendications précédentes, **caractérisé en ce que**, lors de l'introduction du microcomposant (7) dans le logement pour microcomposant (17) le microcomposant (7) est bloqué dans le logement pour microcomposant (17).

5. Procédé selon l'une quelconque des revendications précédentes, **caractérisé par** l'utilisation d'un outil de moulage par injection (42) en plusieurs parties, comprenant une première partie d'outil (43) ayant une première cavité de moulage par injection (45), une deuxième partie d'outil (44) ayant une deuxième cavité de moulage par injection (46), et une vanne d'espace creux (47), dans lequel la première cavité de moulage par injection (45) et la deuxième cavité de moulage par injection (46) déterminent ensemble une forme extérieure du boîtier (2), et dans lequel, pendant l'enrobage de l'élément de support (5, 6) avec le boîtier (2), la vanne d'espace creux (47) s'étend dans la première et/ou la deuxième cavité de moulage par injection (45, 46) pour définir l'espace creux (3).

6. Procédé selon la revendication 5, **caractérisé en ce que**, pour introduire le microcomposant (7) dans le logement pour microcomposant (17), le boîtier (2) reste dans la première partie d'outil (43), et **en ce que** la deuxième partie d'outil (44) et la vanne d'espace creux (47) sont espacées du boîtier (2).

7. Procédé selon l'une quelconque des revendications 5 ou 6, **caractérisé en ce que** le boîtier reste (2) dans la première partie d'outil (43) pour remplir par injection l'espace creux (3) avec le matériau de remplissage (4) et **en ce que** le matériau de remplissage (4) est injecté dans l'espace creux (3) par l'intermédiaire d'une vanne d'injection (56).

8. Procédé selon l'une quelconque des revendications 5 à 7, **caractérisé en ce que** la première cavité de moulage par injection (45) détermine un élément de forme de fixation (9) du boîtier (2).

9. Procédé selon l'une quelconque des revendications 5 à 8, **caractérisé en ce que** la deuxième partie d'outil (44) comprend une vanne d'espace creux de connecteur (48), dans lequel, pendant l'enrobage de l'élément de support (5, 6) avec le boîtier (2), la vanne d'espace creux de connecteur (48) détermine un espace creux de connecteur (10) autour d'une broche de raccordement (11, 12) de l'élément de support (5, 6).

10. Elément de support (5, 6) conçu pour la fabrication d'un composant électronique (1) conformément à un procédé selon l'une quelconque des revendications précédentes, comprenant
- le logement pour microcomposant (17) comportant un élément élastique (20) conçu pour la mise en contact du microcomposant (7),
- une partie d'enrobage conçue pour un enrobage direct avec le boîtier (2) afin de fixer l'élément de support (5, 6) dans le boîtier (2), et
- une broche de raccordement (11, 12), qui est conçue afin qu'elle soit dégagée du boîtier (2) et du matériau de remplissage (4).

11. Elément de support selon la revendication 10, **caractérisé en ce que** l'élément de support (5, 6) est découpé à partir d'une tôle et **en ce que** l'élément élastique (20) est réalisé de manière à solliciter le microcomposant (7) dans une direction (R) parallèle au plan de la tôle.

12. Elément de support selon l'une quelconque des revendications 10 ou 11, **caractérisé en ce que** le logement pour microcomposant (17) comprend une butée (19) pour positionner avec précision le microcomposant (7).

13. Capteur destiné à être utilisé dans un véhicule automobile, comprenant un composant électronique (1) fabriqué conformément à un procédé selon l'une quelconque des revendications 1 à 9, comportant un élément de support (5, 6) selon l'une quelconque des revendications 10 à 12, dans lequel le microcomposant (7) comprend un capteur microélectromécanique (34).
